(19) Europäisches Patentamt
European Patent Office
Office européen des brevets

(11) **EP 3 060 933 B1**

(12) **EUROPÄISCHE PATENTSCHRIFT**

(45) Veröffentlichungstag und Bekanntmachung des Hinweises auf die Patenterteilung:
**25.04.2018 Patentblatt 2018/17**

(21) Anmeldenummer: **14803034.9**

(22) Anmeldetag: **23.10.2014**

(51) Int Cl.:
**G01R 33/028** (2006.01)

(86) Internationale Anmeldenummer:
**PCT/AT2014/050254**

(87) Internationale Veröffentlichungsnummer:
**WO 2015/058229 (30.04.2015 Gazette 2015/17)**

(54) **GRADIENTENMAGNETOMETER UND VERFAHREN ZUR BESTIMMUNG EINER EINZELNEN KOMPONENTE EINES GRADIENTENTENSORS EINES MAGNETFELDS**

GRADIENT MAGNETOMETER AND METHOD FOR DETERMINING AN INDIVIDUAL COMPONENT OF A GRADIENT TENSOR OF A MAGNETIC FIELD

MAGNÉTOMÈTRE À GRADIENTS, ET PROCÉDÉ DE DÉTERMINATION D'UN COMPOSANT INDIVIDUEL D'UN CAPTEUR À GRADIENTS D'UN CHAMP MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.10.2013 AT 8212013**

(43) Veröffentlichungstag der Anmeldung:
**31.08.2016 Patentblatt 2016/35**

(73) Patentinhaber: **Technische Universität Wien**
**1040 Wien (AT)**

(72) Erfinder:
• **KEPLINGER, Franz**
**A-1210 Wien (AT)**
• **STIFTER, Michael**
**A-2620 Neunkirchen (AT)**

(74) Vertreter: **KLIMENT & HENHAPEL**
**Patentanwälte OG**
**Singerstrasse 8/3/9**
**1010 Wien (AT)**

(56) Entgegenhaltungen:
**DE-A1- 19 809 742        US-A1- 2006 181 273**
**US-A1- 2010 295 546**

• **AGUSTÍN L. HERRERA-MAY ET AL: "Resonant Magnetic Field Sensors Based On MEMS Technology", SENSORS, Bd. 9, Nr. 10, 30. September 2009 (2009-09-30), Seiten 7785-7813, XP055166648, ISSN: 1424-8220, DOI: 10.3390/s91007785**

**Beschreibung**

GEBIET DER ERFINDUNG

Die vorliegende Erfindung bezieht sich auf ein Gradientenmagnetometer umfassend eine Anordnung mehrerer Sensoren, wobei jeder Sensor einen geradlinigen Balken umfasst, welcher in seiner Längsrichtung gesehen in einem Anfangsbereich und einem Endbereich fixiert ist und dazwischen frei schwingen kann, jeder Sensor weiters umfassend mindestens ein am Balken angeordnetes und mit diesem verbundenes Leitmittel, um einen Stromfluss in Form von bewegten Ladungsträgern zwischen dem Anfangsbereich und dem Endbereich zu ermöglichen, wobei das mindestens eine Leitmittel mit einer Wechselspannung beaufschlagbar ist, um unter Ausnutzung der Lorentz-Kraft eine Schwingungsmode des Balkens anzuregen, wenn sich der Balken in einem Magnetfeld befindet, wobei mindestens zwei Sensoren miteinander mechanisch gekoppelt sind, um bei Anregung einer Schwindung der Balken dieser mindestens zwei Sensoren dieselbe Schwingungsfrequenz zu erzwingen.

Weiters betrifft die vorliegende Erfindung ein Verfahren zur Bestimmung einer einzelnen Komponente eines Gradiententensors eines Magnetfelds unter Verwendung eines Sensors mit einem geradlinigen Balken, welcher in seiner Längsrichtung gesehen in einem Anfangsbereich und einem Endbereich fixiert ist und dazwischen frei schwingen kann, der Sensor weiters umfassend mindestens ein am Balken angeordnetes und mit diesem verbundenes Leitmittel, um einen Stromfluss in Form von bewegten Ladungsträgern zwischen dem Anfangsbereich und dem Endbereich zu ermöglichen, das Verfahren umfassend die folgenden Schritte:

- Anregen einer vorzugsweise antisymmetrischen Schwingungsmode des Balkens des Sensors durch Ausnutzung der Lorentz-Kraft, indem das mindestens eine Leitmittel mit einer Wechselspannung mit einer Frequenz $f_i$ beaufschlagt wird, wobei $f_i$ eine Frequenz einer Schwingungsmode des Balkens ist.

STAND DER TECHNIK

Die Messung eines Gradienten eines Magnetfelds spielt in unterschiedlichsten Gebieten der Technik und Wissenschaft eine Rolle. Beispielsweise dient sie der Positionsbestimmung eines Zahnrads in einem ABS-Sensor für ein Fahrzeug oder zur genauen Vermessung des Erdmagnetfelds.

Die Stärke des Magnetfelds kann durch die magnetische Flussdichte B beschrieben werden. Deren Gradient ergibt sich aus der Änderung von B pro Einheitsdistanz in der Richtung der größten Änderung von B. Da B eine vektorielle Größe ist, die im Allgemeinen selbst eine Funktion aller drei räumlichen Koordinaten ist, handelt es sich bei dem Gradienten grundsätzlich um einen Tensor bestehend aus sämtlichen partiellen Ableitungen der drei räumlichen B-Feld-Komponenten nach den räumlichen Koordinaten.

In der Praxis werden zur Messung des Gradienten meist zwei Magnetfeldsensoren, z.B. Hall-Sensoren, verwendet, die die Größe von B an zwei verschiedenen, in einem wohldefinierten Abstand voneinander befindlichen Orten messen. Hierauf wird die Differenz der gemessenen Werte für B gebildet und durch den Abstand dividiert. Der Abstand ist dabei so zu wählen, dass sichergestellt ist, dass das B-Feld linear innerhalb des Abstands variiert. Dies wird dadurch erreicht, dass der Abstand zwischen den Sensoren klein ist im Vergleich zur Distanz zwischen den Positionen der Sensoren und der Quelle des Magnetfelds.

Diese Methode mit zwei Sensoren hat den fundamentalen, nicht vermeidbaren Nachteil, dass es keine vollständig identischen Sensoren gibt, d.h. die Sensoren werden immer zumindest geringfügig unterschiedliche Charakteristika aufweisen, weshalb die Differenz der gemessenen B-Felder äußerst anfällig für Fehler ist.

Außerdem weisen die Sensoren nur eine beschränkte Empfindlichkeit auf, die es notwendig macht, die beiden Sensoren relativ weit voneinander entfernt zu platzieren, um Unterschiede in B feststellen zu können, was natürlich die räumliche Auflösung herabsetzt. Dies lässt sich auch dann nicht vermeiden, wenn nur ein Sensor verwendet wird, der hintereinander an den zwei unterschiedlichen Orten für die B-Messung positioniert wird.

Die Publikation A.L. Herrera-May et al., "Resonant Magnetic Field Sensors Based on MEMS Technology", Sensors 2009, 9, 7785-7813 offenbart einen Sensor zur Bestimmung einer einzelnen Komponente der magnetischen Flussdichte. Der Sensor weist hierbei einen Balken auf, der in einem Anfangsbereich und einem Endbereich fixiert ist und dazwischen frei schwingen kann. Zur Schwingungsanregung wird dabei die Lorentz-Kraft ausgenützt, indem ein Wechselstrom durch ein am Balken vorgesehenes Leitmittel geleitet wird, wenn sich der Sensor in einem Magnetfeld befindet. Die Größe der Auslenkung ist dabei proportional zur magnetischen Flussdichte.

Aus der WO 2005/062064 A1 ist ein Sensor bekannt, der zur Detektion eines Gradienten der magnetischen Flussdichte verwendet werden kann. Der Sensor weist hierzu mehrere parallele Balken auf, wobei entlang jedes Balkens Strom geleitet werden kann. Die Balken sind durch ein Schwingelement miteinander verbunden, dessen Auslenkung bzw. Verschiebung bestimmt werden kann. Zur Detektion eines Gradienten der magnetischen Flussdichte werden entlang einander gegenüberliegenden Balken entgegengesetzte Wechselstrom geleitet. Bei Vorliegen eines Gradienten des Magnetfelds kommt es zu einer Verschiebung des Schwingelements, da sich die auftretenden Lorentz-Kräfte nicht ausgleichen. Bzw. führt im Falle eines zusätzlichen Antriebs, mit welchem dem Schwingelement eine Schwingung aufgeprägt wird, die netto resultierende Lorentz-Kraft dazu, dass die Amplitude, mit der das Schwingelement schwingt, geändert wird.

Aus der WO 00/68702 A1 ist es bekannt, eine einzelne leitfähige Saite, die an beiden Enden eingespannt ist, durch Beaufschlagung mit einem Wechselstrom unter Ausnutzung der sich in einem Magnetfeld ergebenden Lorentz-Kraft in Schwingungen zu versetzen. Auf Basis von Messungen der Amplitude wird ein entlang der Saite auftretender Gradient der magnetischen Flussdichte berechnet.

In der US 2006/181273 A1 ist ein Magnetometer offenbart, das einen ersten und einen zweiten Balken aufweist, die mechanisch über eine isolierende Brücke miteinander gekoppelt sind, sodass in Aufsicht auf die Vorrichtung eine H-Form gegeben ist. Der erste Balken wird zum Schwingen angeregt, wobei aufgrund der mechanischen Kopplung auch der zweite Balken mit derselben Frequenz oszilliert. In Anwesenheit eines Magnetfelds wird durch die Schwingungen eine oszillierende Spannung im zweiten Balken induziert, die an Abgreifpunkten abgegriffen werden kann, wobei der zweite Balken elektrisch mit den Abgreifpunkten verbunden ist. Da die Amplitude der induzierten Spannung von der Größe des Magnetfelds abhängt, kann somit die Größe des Magnetfelds bestimmt werden. Um auf die Größe - nicht jedoch auf Tensorkomponenten - eines Magnetfeldgradienten schließen zu können, wird eine Vorrichtung mit mehreren H-förmigen Strukturen vorgeschlagen, wobei eine spezielle Verdrahtung zusätzlicher Leiterbahnen, die auf einer isolierenden Siliziumnitrid-Lage aufgebracht sind, erfolgt. Dabei werden wiederum induzierte Spannungen gemessen.

Aus der US 2010/295546 A1 ist ein Gradientenmagnetometer bekannt, umfassend eine elastisch verformbare Membran, auf der ein Permanentmagnet angeordnet ist. Wird dieser einem Feldgradienten ausgesetzt, bewirkt das resultierende Drehmoment eine Deformation der Membran, die gemessen werden kann, um auf den Feldgradienten zu schließen.

Aus der DE 19809742 A1 ist ein Magnetfeldsensor mit einer Leiterschleife bekannt, welche deformierbare Längsseiten aufweist. Durch eine geeignete mechanische Anregung wird eine oszillierende Flächenänderung der Fläche der Leiterschleife erzeugt, welche in Gegenwart eines Magnetfelds eine induzierte Spannung an Anschlusspads erzeugt.

AUFGABE DER ERFINDUNG

Es ist daher Aufgabe der vorliegenden Erfindung, ein Gradientenmagnetometer bzw. ein Verfahren für die Bestimmung einzelner Komponenten eines Gradiententensors eines Magnetfelds zur Verfügung zu stellen, bei dem die oben genannten Nachteile vermieden werden. Insbesondere soll eine verbesserte räumliche Auflösung erzielt werden.

DARSTELLUNG DER ERFINDUNG

Ein geradliniger Balken, der an seinem Anfangs- und Endbereich in seiner Längsrichtung fixiert ist und dazwischen frei schwingen kann, kann in einem Magnetfeld durch Ausnutzung der Lorentz-Kraft zum Schwingen mit einer Schwingungsmode des Balkens angeregt werden, wobei die Amplitude der angeregten Schwingungsmode direkt proportional zu einer einzelnen Komponente des Gradiententensors des Magnetfeldes bzw. der magnetischen Flussdichte B ist. Kern der vorliegenden Erfindung ist, dass durch mechanische Kopplung mindestens zweier solcher Balken - im Gegensatz zur Verwendung von zwei unabhängig und beabstandet voneinander schwingender Balken - systematische Fehler verhindert werden können und so auf einfache Art und Weise ein präzises Gradientenmagnetometer realisiert werden kann.

Um die Anregung der Schwingungsmode mittels Lorentz-Kraft zu ermöglichen, ist mindestens ein - elektrisches - Leitmittel vorgesehen, welches am jeweiligen Balken angeordnet und mit diesem verbunden ist, um einen Stromfluss in Form von bewegten Ladungsträgern zwischen dem Anfangs- und Endbereich zu ermöglichen. Bewegen sich die Ladungsträger in einem Magnetfeld, wirkt auf diese die Lorentz-Kraft. Aufgrund der Kopplung zwischen dem mindestens einen Leitmittel und dem Balken wirkt auch auf diesen die Lorentz-Kraft. Wird nun das mindestens eine Leitmittel mit einer Wechselspannung beaufschlagt und befindet sich der Balken in einem Magnetfeld, so wird aufgrund der sich ergebenden oszillierenden Lorentz-Kraft eine Schwingung des Balkens angeregt. Grundsätzlich verhält sich der Balken dabei wie eine schwingende Saite, die an ihren beiden Enden fixiert ist. Entsprechend existieren Schwingungsmoden des Balkens, welche unter Ausnutzung einer Resonanz angeregt werden können. Dies funktioniert grundsätzlich unabhängig davon, ob das B-Feld im Mittel null ist oder nicht, genauer unabhängig davon, ob der Gradient von einem Gleichfeld gleich oder ungleich null überlagert ist.

Daher ist es bei einem Sensor für ein Gradientenmagnetometer erfindungsgemäß vorgesehen, dass der Sensor einen geradlinigen Balken umfasst, welcher in seiner Längsrichtung gesehen in einem Anfangsbereich und einem Endbereich fixiert ist und dazwischen frei schwingen kann, der Sensor weiters umfassend mindestens ein am Balken angeordnetes und mit diesem verbundenes Leitmittel, um einen Stromfluss in Form von bewegten Ladungsträgern zwischen dem Anfangsbereich und dem Endbereich zu ermöglichen, wobei das mindestens eine Leitmittel mit einer Wechselspannung beaufschlagbar ist, um unter Ausnutzung der Lorentz-Kraft eine Schwingungsmode des Balkens anzuregen, wenn sich der Balken in einem Magnetfeld befindet.

Die Kräfte, die aufgrund des Gradienten entlang des Balkens auftreten, sind natürlich relativ klein. Um den zu messenden Effekt zu verstärken, ist ein zweiter Sensor bzw. ein zweiter Balken vorgesehen, der parallel zum ersten Balken verläuft. Um sicherzustellen, dass beide Balken mit derselben Frequenz schwingen, werden die beiden Balken miteinander mechanisch gekoppelt. Diese Anordnung hat gegenüber einem einzelnen Sensor eine erhöhte Empfindlichkeit hinsichtlich einer Komponente des Magnetfeldgradienten mit einer partiellen Ableitung in jener Raumrichtung, die der Längsrichtung des bzw. der Balken entspricht (im Folgenden der Einfachheit halber als Komponente des Magnetfeldgradienten "entlang" der Längsrichtung bezeichnet).

Ein weiterer Vorteil dieser Anordnung liegt darin, dass sich durch eine Beabstandung der zwei Sensoren bzw. Balken in einer Richtung normal auf die Längsrichtung, vorzugsweise in der ersten Richtung, gleichzeitig eine Sensitivität der Anordnung auf eine Komponente eines Magnetfeldgradienten entlang dieser Richtung ergibt, also die Detektion einer Komponente des Magnetfeldgradienten mit einer partiellen Ableitung in dieser Richtung ermöglicht.

Daher ist es bei einem Gradientenmagnetometer umfassend eine Anordnung mehrerer Sensoren, wobei jeder Sensor einen geradlinigen Balken umfasst, welcher in seiner Längsrichtung gesehen in einem Anfangsbereich und einem Endbereich fixiert ist und dazwischen frei schwingen kann, jeder Sensor weiters umfassend mindestens ein am Balken angeordnetes und mit diesem verbundenes Leitmittel, um einen Stromfluss in Form von bewegten Ladungsträgern zwischen dem Anfangsbereich und dem Endbereich zu ermöglichen, wobei das mindestens eine Leitmittel mit einer Wechselspannung beaufschlagbar ist, um unter Ausnutzung der Lorentz-Kraft eine Schwingungsmode des Balkens anzuregen, wenn sich der Balken in einem Magnetfeld befindet, wobei mindestens zwei Sensoren miteinander mechanisch gekoppelt sind, um bei Anregung einer Schwindung der Balken dieser mindestens zwei Sensoren dieselbe Schwingungsfrequenz zu erzwingen, erfindungsgemäß vorgesehen, dass für jeden Sensor mindestens ein Auslesemittel vorgesehen ist, um eine Amplitude der Schwingung des Balkens des jeweiligen Sensors zu bestimmen.

Grundsätzlich sind Schwingungen des Balkens mit Amplituden in unterschiedlichen Richtungen denkbar. Entsprechend können prinzipiell durch Bestimmung dieser unterschiedlichen Amplituden unterschiedliche einzelne Komponenten des Gradiententensors bestimmt werden. Dabei ist die betreffende Komponente des Gradiententensors eine B-Feld-Komponente partiell abgeleitet nach jener räumlichen Koordinate, die der Längsrichtung des Balkens entspricht. Um welche räumliche B-Feld-Komponente es sich handelt, hängt von der räumlichen Richtung ab, entlang derer die Amplitude gemessen wird. Konkret ergibt sich die Richtung der jeweiligen Amplitude aus dem Kreuzprodukt zwischen der Richtung des (Wechsel-)Stroms und der betreffenden B-Feld-Komponente.

Eine einfache Detektion wird erreicht, indem Schwingungen mit einer Amplitude in einer bevorzugten Richtung ermöglicht werden. Um vor allem Schwingungen mit einer Amplitude in einer bevorzugten Richtung zu ermöglichen, ist es bei einer bevorzugten Ausführungsform des erfindungsgemäßen Gradientenmagnetometers vorgesehen, dass der Balken jedes Sensors in Längsrichtung zwischen dem Anfangsbereich und dem Endbereich eine Länge aufweist, dass der Balken in einer ersten Richtung normal auf die Längsrichtung eine Breite aufweist und in einer zweiten Richtung, die normal auf die Längsrichtung und die erste Richtung steht, eine Höhe, wobei die Höhe kleiner als die Breite ist und die Breite kleiner als die Länge. Indem der Balken also hauptsächlich in einer Dimension ausgeprägte Abmessungen aufweist, wird einerseits erreicht, dass auch der elektrische Strom im Leitmittel im Wesentlichen eindimensional verläuft. Andererseits hat die Dimensionierung des Balkens stark unterschiedliche axiale Flächenträgheitsmomente um die bzw. bezüglich der unterschiedlichen Raumrichtungen zur Folge. Beides bewirkt, dass insbesondere Schwingungen mit einer Amplitude in der zweiten Richtung angeregt werden.

Zur Messung der Amplituden der Schwingung der Balken der Sensoren des Gradientenmagnetometers sei bemerkt, dass nicht notwendigerweise die Amplitude in der zweiten Richtung gemessen werden muss; es kann grundsätzlich auch die Amplitude in einer anderen, beliebigen Richtung, insbesondere in der ersten Richtung gemessen werden. Außerdem können pro Balken Amplituden in mehreren Richtungen gleichzeitig bestimmt werden, z.B. sowohl die Amplitude in der ersten Richtung als auch die Amplitude in der zweiten Richtung. In diesem Fall bietet es sich natürlich an, bei jedem Sensor bzw. Balken für jede zu messende Amplitude ein eigenes Auslesemittel vorzusehen.

Besonders ausgeprägt wird dieses Verhalten, wenn eine oder mehrere Größenordnungen zwischen den Abmessungen des Balkens entlang der unterschiedlichen Raumrichtungen liegen. Daher ist es bei einer bevorzugten Ausführungsform des erfindungsgemäßen Gradientenmagnetometers vorgesehen, dass die Breite mindestens zehnmal größer, vorzugsweise mindestens dreißigmal größer, als die Höhe ist und die Länge mindestens zehnmal größer, vorzugsweise mindestens dreißigmal größer als die Breite. Die Verhältnisse der axialen Flächenträgheitsmomente bezüglich der unterschiedlichen Richtungen stehen zueinander daher in einem Verhältnis von mindestens 1:100, entsprechend des quadratischen Verhältnisses von Breite zu Länge bzw. von Höhe zu Breite.

Um Sensoren mit einer wohldefinierten Struktur und wohldefinierten mechanischen Eigenschaften des Balkens herstellen zu können, ist es bei einer bevorzugten Ausführungsform des erfindungsgemäßen Gradientenmagnetometers vorgesehen, dass der Balken jedes Sensors aus vorzugsweise einkristallinem Silizium gefertigt ist. Dies ermöglicht beispielsweise die Herstellung auf Basis eines Silizium-Wafers in einem sogenannten, an sich bekannten Silicon-On-Insulator (SOI)-Verfahren.

Eine herstellungstechnisch vorteilhafte Ausführungsform ergibt sich, indem als Leitmittel eine Leiterbahn, vorzugsweise aus Gold, vorgesehen ist. Die Leiterbahn verläuft entsprechend entlang der Längsrichtung des Balkens. Daher ist es bei einer bevorzugten Ausführungsform des erfindungsgemäßen Gradientenmagnetometers vorgesehen, dass das mindestens eine Leitmittel eine Leiterbahn umfasst, die auf einer Oberfläche des Balkens jedes Sensors fixiert ist.

Um einen Schutz des mindestens einen Leitmittels gegen äußere Einflüsse sicherzustellen, ist es bei einer weiteren bevorzugten Ausführungsform des erfindungsgemäßen Gradientenmagnetometers vorgesehen, dass das mindestens eine Leitmittel in den Balken jedes Sensors integriert ist. In diesem Fall kann das mindestens eine Leitmittel beispielsweise als mikromechanische Struktur aus Metall, insbesondere aus Aluminium ausgeführt sein.

Um auszuschließen, dass das mindestens eine Leitmittel durch die Schwingungen des Balkens mechanisch beschädigt oder gar zerstört wird, ist es bei einer besonders bevorzugten Ausführungsform des erfindungsgemäßen Gradientenmagnetometers vorgesehen, dass der Balken und das mindestens eine Leitmittel jedes Sensors einstückig ausgeführt sind. D.h. in diesem Fall ist der Balken zumindest abschnittsweise selbst elektrisch leitend.

Bei einer herstellungstechnisch besonders vorteilhaften Ausführungsform des erfindungsgemäßen Gradientenmagnetometers ist es vorgesehen, dass genau zwei Sensoren vorgesehen sind, deren Balken mittels mindestens eines Kopplungselements miteinander verbunden sind, wobei die Anordnung im Wesentlichen eine H-Form aufweist. Die Anordnung muss keine perfekte Symmetrie aufweisen, d.h. das mindestens eine Kopplungselement muss z.B. nicht perfekt mittig bezüglich der Länge der Balken angeordnet sein. Darüberhinaus ist es für die Gewährleistung der Funktion der Sensoren nicht notwendig, dass der Querschnitt der Balken normal auf die Längsrichtung über die gesamte Länge der Balken homogen bzw. konstant ist. Entsprechend ist im Allgemeinen von keiner symmetrischen Anordnung auszugehen.

Herstellungstechnisch besonders vorteilhaft ist es, wenn die Balken der beiden Sensoren nur in der ersten oder zweiten Richtung versetzt zueinander angeordnet sind. Eine derartige Anordnung lässt sich leicht mittels der bereits erwähnten SOI-Technologie erzeugen. Entsprechend ist es bei einer bevorzugten Ausführungsform des erfindungsgemäßen Gradientenmagnetometers vorgesehen, dass die Balken der beiden Sensoren parallel zueinander verlaufen und im Wesentlichen nur in der ersten Richtung voneinander beabstandet sind.

Fertigungstechnische Imperfektionen sind natürlich in der Praxis nicht auszuschließen, d.h. es kann natürlich sein, dass es auch bezüglich der zweiten Richtung zu einer geringfügigen Beabstandung kommt. Diese Imperfektionen stellen jedoch keine Abweichung von der beanspruchten Ausführungsform dar.

Die SOI-Technologie gestattet es, die Balken der beiden Sensoren sowie das mindestens eine, die Balken verbindende Kopplungselement auf einfache Weise einstückig herzustellen. Es fallen also keine zusätzlichen Arbeitsschritte für eine Fixierung des mindestens einen Kopplungselements an den Balken an. Zudem wird eine sehr gut definierte Anordnung erhalten. Entsprechend ist es bei einer bevorzugten Ausführungsform des erfindungsgemäßen Gradientenmagnetometers vorgesehen, dass die beiden Balken und das mindestens eine Kopplungselement einstückig ausgeführt sind.

Um ein Wölben der Balken bzw. der H-förmigen Anordnung aufgrund einer thermisch bedingten Ausdehnung zu unterbinden, ist es bei einer besonders bevorzugten Ausführungsform des erfindungsgemäßen Gradientenmagnetometers vorgesehen, dass jeder Balken in seinem Anfangsbereich und in seinem Endbereich an jeweils einem als Kragarm ausgeführten Ankerelement fixiert ist. Die derart ausgeführten Ankerelemente unterliegen selbst einer thermischen Ausdehnung und sind so zur H-förmigen Anordnung angeordnet, dass die thermische Ausdehnung der H-förmigen Anordnung kompensiert wird, wodurch ein Wölben verhindert wird.

Bei einer herstellungstechnisch besonders vorteilhaften Ausführungsform des erfindungsgemäßen Gradientenmagnetometers ist es vorgesehen, dass jeder Balken und die zugehörigen Ankerelemente einstückig ausgeführt sind. Vorzugsweise wird auch in diesem Fall zur Herstellung die SOI-Technologie verwendet.

Um die Amplitude/n zu bestimmen sind unterschiedliche Auslesemittel einsetzbar. Ein besonders einfach zu realisierendes Auslesemittel ist ein kapazitives Ausleseelement. Dieses kann gebildet werden durch den Balken selbst und eine unter dem Balken angeordnete Elektrode. Vorzugsweise verläuft die Elektrode zumindest abschnittsweise parallel zum Balken, wenn dieser nicht schwingt und in einer Ausgangsposition ist. Die Elektrode und der Balken bilden im Prinzip einen Kondensator mit einer gewissen Kapazität, die vom Abstand zwischen Elektrode und Balken abhängt. Schwingt der Balken, so ändert sich in Abhängigkeit von dessen Auslenkung bzw. von der Amplitude der Schwingung die Kapazität. Entsprechend kann aus der Messung der Kapazitätsänderung auf die Amplitude und damit auf die Größe bzw. auf den Betrag der Komponente des Magnetfeldgradiententensors geschlossen werden. Entsprechend ist es bei einer bevorzugten Ausführungsform des erfindungsgemäßen Gradientenmagnetometers vorgesehen, dass als das jeweilige mindestens eine Auslesemittel ein kapazitives Ausleseelement vorgesehen ist.

Selbstverständlich sind auch andere, an sich bekannte Verfahren zur Messung der Amplitude einer Schwingung des jeweiligen Balkens anwendbar. Entsprechend ist es bei einer bevorzugten Ausführungsform des erfindungsgemäßen Gradientenmagnetometers vorgesehen, dass als das jeweilige mindestens eine Auslesemittel ein piezoelektrisches oder piezoresistives oder optisches Ausleseelement vorgesehen ist.

Wie bereits geschildert, wird zur Bestimmung einer einzelnen Komponente des Gradiententensors von B eine Schwingungsmode des Balkens angeregt und die Amplitude der angeregten Schwingungsmode gemessen. Eine optimale, resonante Anregung wird erreicht, indem die Wechselspannung bzw. der sich ergebende Wechselstrom eine Frequenz $f_i$ aufweist, wobei $f_i$ eine Frequenz einer Schwingungsmode des Balkens ist. Die Größe der Komponente des Gradiententensors von B ergibt sich durch Multiplikation der gemessenen Amplitude mit einem Proportionalitätsfaktor. Hierzu sei bemerkt, dass grundsätzlich sowohl symmetrische als auch antisymmetrische Schwingungsmoden angeregt werden können, wobei prinzipiell in beiden Fällen die Bestimmung der Größe der Tensorkomponente möglich ist. Bei Überlagerung des Gradienten durch ein Gleichfeld ungleich null kann die Anregung einer antisymmetrischen Schwingungsmode zur Bestimmung der Größe der Komponente des Gradiententensors von B vorteilhaft sein, um eine Unterscheidung zwischen Gleichfeld-Komponente und Gradiententensor-Komponente zu vereinfachen.

Der genannte Zusammenhang zwischen der Gradiententensorkomponente und der Amplitude folgt aus der Euler-Bernoulli Balkentheorie über das mechanische Verhalten belasteter Balken, welche in Standardlehrbüchern zu finden ist, wie z.B. in Stephen P. Timoshenko, James M. Gere, "Theory of Elastic Stability", 2nd Ed., McGraw-Hill (1985) oder Kurt Magnus, Karl Popp, "Schwingungen", 7. Auflage, Vieweg+Teubner Verlag (2005). Auf diese Weise lässt sich die Auslenkung $w(x)$ einer Brücke bzw. eines Balkens, welcher sich mit einer Länge $l$ entlang der Richtung x (entspricht der Längsrichtung) erstreckt, an seinen Enden fixiert ist und dazwischen frei schwingen kann, bestimmen. Für die Auslenkung $w(x)$ in einer allgemeinen Richtung a, die normal auf die Richtung x steht, ergibt sich folgender Ausdruck:

$$w(x) = q/(E \star J_{a'}) \star (x^4/24 - x^3 l/12 + x^2 l^2/24),$$

wobei q eine Gleichlast ist, die die Auslenkung des Balkens bewirkt, E der Elastizitätsmodul des Balkens und $J_a$, das axiale Flächenträgheitsmoment bezüglich einer normal auf die Richtung x und normal auf die allgemeine Richtung a stehenden Normalrichtung a'. Davon ausgehend, dass - bei einer ersten symmetrischen Schwingungsmode - in der Mitte des Balkens die größte Auslenkung auftritt, kann man diese Formel für die Position in der Balkenmitte, d.h. bei x=1/2, auswerten, um die Amplitude $A_a$ der Schwingung des Balkens in der allgemeinen Richtung a zu erhalten:

$$A_a = w(l/2) = (q \star l^4)/(384 \star E \star J_{a'}).$$

Die Gleichlast q, die die Auslenkung des Balkens bewirkt, wird im vorliegenden Fall durch die Lorentz-Kraft $F_L$ erzeugt, und es gilt daher

$$A_a = (F_L \star l^3)/(384 \star E \star J_{a'}).$$

Bei Vorliegen eines Gradiententensors ergibt sich die Lorentz-Kraft $F_L$ grundsätzlich als Produkt des Gradienten von B mit dem magnetischen Moment, das sich wiederum aus dem Stromfluss im Leitmittel und der vom Stromfluss umschlossenen Fläche ergibt. Für die Amplitude $A_a$, die die maximale Auslenkung in der allgemeinen Richtung a, d.h. normal auf die Richtung x und normal auf die Normalrichtung a', darstellt, ist die Lorentz-Kraft $F_L$ aufgrund der Tensorkomponente $\partial B_{a'}/\partial x$ verantwortlich, d.h.

$$A_a = \partial B_{a'}/\partial x \star m \star l^3/(384 \star E \star J_{a'}).$$

Entsprechend gilt für die Tensorkomponente

$$\partial B_{a'}/\partial x = A_a \star (384 \star E \star J_{a'})/(m \star l^3).$$

Allgemein lässt sich daher sagen, dass die Tensorkomponente $\partial B_{a'}/\partial x$ proportional zur Amplitude $A_a$ ist mit einem Proportionalitätsfaktor $\alpha$, der von E, $J_{a'}$, m und l abhängt, also:

$$\partial B_{a'}/\partial x = A_a \star \alpha(E, J_{a'}, m, l).$$

Es sei bemerkt, dass diese allgemeine Form auch dann zutreffend ist, wenn Torsionen und damit einhergehende Änderungen des Schubmoduls des Balkens bzw. der schwingenden Struktur nicht vernachlässigt werden können. Der Faktor $\alpha$ kann in diesem Fall völlig analog zu obiger Darstellung aus der Euler-Bernoulli-Balkentheorie bestimmt werden.

Daher ist es bei einem Verfahren zur Bestimmung einer einzelnen Komponente eines Gradiententensors eines Magnetfelds unter Verwendung eines erfindungsgemäßen Sensors vorgesehen, dass das Verfahren die folgenden Schritte umfasst:

- Anregen einer vorzugsweise antisymmetrischen Schwingungsmode des Balkens des Sensors durch Ausnutzung der Lorentz-Kraft, indem das mindestens eine Leitmittel mit einer Wechselspannung mit einer Frequenz $f_i$ beaufschlagt wird, wobei $f_i$ eine Frequenz einer Schwingungsmode des Balkens ist;
- Bestimmung einer Amplitude der angeregten Schwingung;
- Berechnung der Größe der Komponente gemäß der folgenden Formel:

$$\texttt{K = A}_\texttt{a}\ \texttt{*}\ \alpha\texttt{(E,J}_\texttt{a'}\texttt{,m,l),}$$

wobei K die Komponente der magnetischen Flussdichte in einer Normalrichtung, die normal auf die Richtung der gemessenen Amplitude $A_a$ und normal auf die Längsrichtung steht, partiell abgeleitet nach der Längsrichtung ist und $\alpha$ ein Proportionalitätsfaktor, der vom Elastizitätsmodul E des Balkens, vom axiale Flächenträgheitsmoment $J_{a'}$ des Balkens bezüglich der Normalrichtung, vom magnetischen Moment m, das sich aus dem Stromfluss im Leitmittel und der vom Stromfluss umschlossenen Fläche ergibt, sowie von der Länge l des Balkens abhängt.

Weiters ist es bei einem erfindungsgemäßen Verfahren vorgesehen, dass gleichzeitig mit der Anregung der Schwingung des Balkens des Sensors eine Schwingung des Balkens eines zweiten Sensors, welcher mit dem Sensor mechanisch gekoppelt ist, durch Ausnutzung der Lorentz-Kraft angeregt wird, indem das mindestens eine Leitmittel des zweiten Sensors mit einer Wechselspannung mit derselben Frequenz $f_i$ beaufschlagt wird, und dass die Amplituden der angeregten Schwingung der beiden Balken bestimmt werden.

Um beispielsweise jene Komponente des Gradiententensors zu bestimmen, die die B-Feld-Komponente in der ersten Richtung partiell abgeleitet nach der Längsrichtung ist ("$\partial B_y/\partial x$"), ist es bei einer bevorzugten Ausführungsform des erfindungsgemäßen Verfahrens vorgesehen, dass die Amplitude in der zweiten Richtung gemessen wird und dass die Komponente des Gradiententensors gemäß der folgenden Formel bestimmt wird

$$\texttt{K = A}_\texttt{z}\ \texttt{*}\ \alpha\texttt{(E,J}_\texttt{y}\texttt{,m,l),}$$

wobei K die Komponente der magnetischen Flussdichte in der ersten Richtung partiell abgeleitet nach der Längsrichtung ist, $A_z$ die entlang der zweiten Richtung gemessene Amplitude und $J_y$ das axiale Flächenträgheitsmoment des Balkens bezüglich der ersten Richtung. $\alpha$ ist natürlich wieder der Proportionalitätsfaktor, wobei E klarerweise wieder den Elastizitätsmodul des Balkens bezeichnet, m das magnetische Moment, das sich aus dem Stromfluss im Leitmittel und der vom Stromfluss umschlossenen Fläche ergibt, und l die Länge des Balkens.

Wie bereits festgehalten, ermöglicht die Verwendung der erfindungsgemäßen Anordnung auch die Detektion einer Komponente des Magnetfeldgradienten mit einer partiellen Ableitung in jener auf die Längsrichtung normal stehenden Richtung, in der die beiden Balken zueinander beabstandet sind. Wenn also die beiden Balken in der ersten Richtung beabstandet sind, kann auf einfache Weise die B-Feld-Komponente in der ersten Richtung partiell abgeleitet nach der ersten Richtung ("$\partial B_y/\partial y$") bestimmt werden. Ist diese Komponente des Gradiententensors ungleich null, so kommt es bei Anregung einer jeweils symmetrischen Schwingungsmode der Balken zu einem gegenphasigen Schwingen der Balken. Daher ist es bei einer bevorzugten Ausführungsform des erfindungsgemäßen Verfahrens vorgesehen, dass außerdem bestimmt wird, ob die Schwingung der beiden Balken in Phase oder gegenphasig ist.

Messtechnisch ist das Auftreten von gegenphasigen Schwingungen der Balken von großem Vorteil, da sich hierdurch sehr leicht und ohne zusätzlichen Rechenaufwand ein Differenzsignal der Auslesemittel, mit deren Hilfe die Amplituden gemessen werden, generieren lässt. Beispielsweise wäre die Realisierung eines Differentialkondensators bei einer kapazitiven Auslese der Amplituden möglich.

Im Vorstehenden wurde davon ausgegangen, dass die Wechselspannungen, mit denen die Leitmittel der beiden Balken beaufschlagt werden, bzw. die sich ergebenden Wechselströme in den Leitmitteln gleichphasig sind. Um nun auch in Fällen, wo es grundsätzlich zu einem gleichphasigen Schwingen der Balken kommen würde, ein gegenphasiges Schwingen der Balken und somit verbesserte Messmöglichkeiten zu erzwingen, ist es bei einer bevorzugten Ausführungsform des erfindungsgemäßen Verfahrens vorgesehen, dass die beiden Wechselspannungen gegenphasig sind.

Schließlich sei festgehalten, dass das erfindungsgemäße Gradientenmagnetometer bzw. das erfindungsgemäße Verfahren auch die Bestimmung von B-Feld-Komponenten ermöglicht. Liegt beispielsweise in der ersten Richtung lediglich ein Gleichfeld der magnetischen Flussdichte ungleich null vor, jedoch keine Gradiententensorkomponente ungleich null, so kann mittels Anregung einer symmetrischen Schwingungsmode eines einzelnen Balkens die entsprechende B-Feld-Komponente ("$B_y$") auf dieselbe Art bestimmt werden, wie oben für die Bestimmung der Gradiententensorkomponente geschildert. Hierbei ist lediglich zu berücksichtigen, dass sich in diesem Fall die Lorentz-Kraft $F_L$, welche die auf den Balken wirkende Gleichlast verursacht, betragsmäßig als Produkt aus dem Strom i im Leitmittel, der Länge l des Balkens und der genannten B-Feld-Komponente ergibt. Entsprechend ist die B-Feld-Komponente proportional zur gemessenen Amplitude, womit sich allgemein folgender formaler Zusammenhang ergibt:

$$B_{a'} = A_a * \beta(E, J_{a'}, i, l),$$

wobei $B_{a'}$ die B-Feld-Komponente in der Normalrichtung a' ist und $\beta$ ein Proportionalitätsfaktor, der von E, $J_{a'}$, i und l abhängt.

Für die B-Feld-Komponente in der ersten Richtung y ergibt sich somit:

$$B_y = A_z * \beta(E, J_y, i, l),$$

wobei im oben diskutierten Fall, bei dem die Auslenkung des Balkens in der Balkenmitte bei Gleichlast betrachtet wird,

$$\beta(E, J_y, i, l) = (384 * E * J_y) / (i * l^4)$$

gilt.

Werden eine erfindungsgemäße, H-förmige Anordnung und gleichphasige Wechselspannungen verwendet, so kommt es bei Anregung einer symmetrischen Schwingungsmode der beiden Balken zu einer gleichphasigen Schwingung, wenn in der ersten Richtung lediglich ein Gleichfeld der magnetischen Flussdichte ungleich null vorliegt. Zu Verbesserung der Messung könnten dann natürlich auch in diesem Fall gegenphasige Wechselströme angelegt werden.

Daher ist erfindungsgemäß die Verwendung eines erfindungsgemäßen Gradientenmagnetometers zur Bestimmung einer einzelnen Komponente eines Gradiententensors eines Magnetfelds und/oder zur Bestimmung einer einzelnen Komponente der magnetischen Flussdichte vorgesehen.

KURZE BESCHREIBUNG DER FIGUREN

Die Erfindung wird nun anhand von Ausführungsbeispielen näher erläutert. Die Zeichnungen sind beispielhaft und sollen den Erfindungsgedanken zwar darlegen, ihn aber keinesfalls einengen oder gar abschließend wiedergeben.

Dabei zeigt:

Fig. 1    eine axonometrische Ansicht eines Sensors eines erfindungsgemäßen Gradientenmagnetometers

Fig. 2    eine schematische Schnittansicht des Sensors mit einer Illustration einer symmetrischen Schwingungsmode

Fig. 3    eine schematische Schnittansicht analog zu Fig. 2 mit einer Illustration einer antisymmetrischen Schwingungsmode

Fig. 4    eine axonometrische Ansicht einer H-förmigen Anordnung zweier Sensoren

Fig. 5    eine schematische axonometrische Ansicht der Anordnung aus Fig. 4 mit einer Illustration von gleichphasigen, symmetrischen Schwingungsmoden

Fig. 6    eine schematische axonometrische Ansicht analog zu Fig. 5 mit einer Illustration von gegenphasigen, symmetrischen Schwingungsmoden

Fig. 7    eine Aufsicht auf eine erfindungsgemäße H-förmige Anordnung mit als Kragarme ausgeführten Ankerelementen

Fig. 8    eine Schnittansicht gemäß der Schnittlinie A-A in Fig. 7

WEGE ZUR AUSFÜHRUNG DER ERFINDUNG

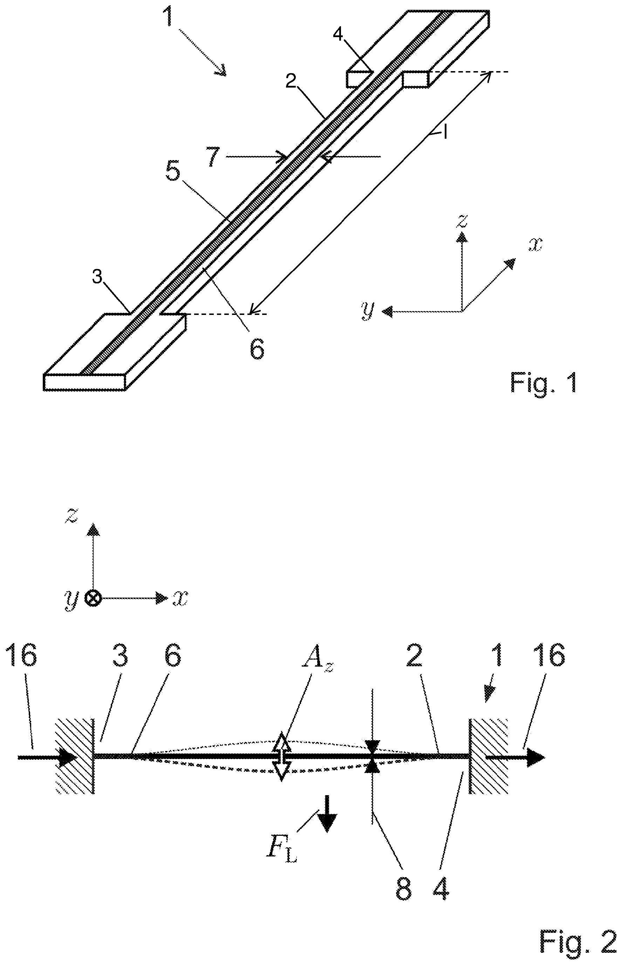

Fig. 1 zeigt in einer axonometrischen Ansicht einen Sensor 1 eines erfindungsgemäßen Gradientenmagnetometers zur Bestimmung einzelner Komponenten eines Gradiententensors eines Magnetfelds bzw. einer magnetischen Flussdichte B. Der Sensor 1 umfasst einen Balken 2 der sich entlang einer Längsrichtung x mit einer Länge l erstreckt. Bezogen auf die Längsrichtung ist der Balken 2 in einem Anfangsbereich 3 und einem Endbereich 4 fixiert und kann zwischen Anfangsbereich 3 und Endbereich 4 frei schwingen - ähnlich zu einer eingespannten Saite.

Der Balken weist im gezeigten Ausführungsbeispiel normal auf die Längsrichtung x einen im Wesentlichen rechteckigen Querschnitt auf mit einer Breite 7 und einer Höhe 8, vgl. Fig. 2. Die Breite 7 wird entlang einer ersten Richtung y gemessen, die Höhe 8 entlang einer zweiten Richtung z, wobei die Richtungen x, y und z gegenseitig normal aufeinander stehen. Selbstverständlich sind jedoch auch Ausführungsvarianten mit einer anderen Querschnittsform denkbar, wobei die Querschnittsform nicht notwendigerweise eckig sein muss, sondern z.B. auch elliptisch sein könnte.

Dabei ist die Länge l deutlich größer als die Breite 7 und die Breite 7 deutlich größer als die Höhe 8. Entsprechend ergeben sich stark unterschiedliche axiale Flächenträgheitsmomente um die bzw. bezüglich der unterschiedlichen Richtungen x, y und z, sodass der Balken bevorzugt in der zweiten Richtung z ausgelenkt werden kann bzw. mit Amplituden in der Richtung z schwingt. Die Darstellung der Fig. 1 ist nicht maßstabsgetreu. Typische Abmessungen sind 2500 $\mu$m für die Länge l, 500 $\mu$m für die Breite 7 und 5 $\mu$m für die Höhe 8.

Auf einer Oberfläche 6 des Balkens 2 ist eine Leiterbahn 5 als elektrisches Leitmittel angeordnet bzw. angebracht, um einen Stromfluss in Form von bewegten Ladungsträgern zwischen dem Anfangsbereich 3 und dem Endbereich 4 zu ermöglichen. Aufgrund der dominierenden Dimension des Balkens 2 in Längsrichtung x kann die Leiterbahn 5 auf der Oberfläche 6 näherungsweise als eindimensionales Element mit Erstreckung in Richtung x aufgefasst werden.

Zur Bestimmung einzelner Komponenten eines Gradiententensors von B wird die Leiterbahn 5 mit einer Wechselspannung beaufschlagt, wenn sich der Sensor 1 im Magnetfeld befindet. Aufgrund des sich ergebenden Wechselstroms 16 in der Leiterbahn 5 wirkt die Lorentz-Kraft $F_L$ auf die sich in der Leiterbahn 5 bewegenden Ladungsträger und in der Folge auf den Balken 2. Da es sich um einen Wechselstrom handelt, ändert die Lorentz-Kraft $F_L$ zeitlich ihr Vorzeichen und bewirkt somit eine abwechselnde Auslenkung bzw. eine Schwingung des Balkens 2. Indem eine ge-eignete Frequenz $f_i$ des Wechselstroms 16 gewählt wird, können Schwingungsmoden des Balkens 2 resonant angeregt werden.

Fig. 2 illustriert die Situation für eine senkrecht auf die Zeichenebene stehende Flussdichte B und eine symmetrische Schwingungsmode des Balkens 2. D.h. B ist parallel zur Richtung y bzw. weist eine Komponente in der ersten Richtung y auf, $B_y$, die ungleich null ist, also $B_y \neq 0$. Die Amplitude $A_z$ der Schwingungsmode ergibt sich als maximale Auslenkung des Balkens 2 parallel zur Richtung z, wobei die Auslenkung in Fig. 2 durch die strichlierte bzw. punktierte Linie angedeutet ist. Dabei ist die maximale Auslenkung in Richtung z bzw. die Amplitude $A_z$ direkt proportional zu $B_y$.

Für die Möglichkeit, den einzelnen Sensor 1 zur Bestimmung einer Komponente K des Gradiententensors von B einzusetzen, ist entscheidend, dass in einer allgemeinen Richtung a eine Amplitude $A_a$ gemessen wird. Die zu bestimmende Komponente K ist dann die magnetischen Flussdichte B in einer Normalrichtung a', die normal auf die Richtung der gemessenen Amplitude $A_a$ und normal auf die Längsrichtung x steht, partiell abgeleitet nach der Längs-richtung x, also "$\partial B_a/\partial x$". Die Komponente K ist proportional zur Amplitude $A_a$ mit einem Proportionalitätsfaktor $\alpha$, der vom Elastizitätsmodul E des Balkens 2, dem axialen Flächenträgheitsmoment $J_{a'}$ des Balkens 2 bezüglich der Normalrichtung a', dem magnetischen Moment m, das sich aus dem Wechselstrom 16 bzw. Stromfluss im Leitmittel bzw. in der Leiterbahn 5 und der vom Stromfluss umschlossenen Fläche ergibt, und von der Länge l des Balkens 2 abhängt, konkret:

$$\mathrm{K} \;=\; \partial \mathrm{B}_{a'}/\partial \mathrm{x} \;=\; \mathrm{A}_a \;*\; \alpha(\mathrm{E}, \mathrm{J}_{a'}, \mathrm{m}, \mathrm{l}).$$

Unter Vernachlässigung von Torsionen und davon ausgehend, dass - entsprechend einer ersten symmetrischen Schwingungsmode - die maximale Auslenkung des Balkens 2 bezüglich seiner Ausdehnung in Längsrichtung x in der Mitte, d.h. bei 1/2 auftritt, ergibt sich für den Proportionalitätsfaktor

$$\alpha(\mathrm{E}, \mathrm{J}_{a'}, \mathrm{m}, \mathrm{l}) \;=\; (384 * \mathrm{E} * \mathrm{J}_{a'})/(\mathrm{m} * \mathrm{l}^3).$$

Somit ist die Amplitude $A_z$ einer Schwingungsmode proportional zur entsprechenden partiellen Ableitung von $B_y$ nach einer räumlichen Koordinate, die der Längsrichtung x entspricht. D.h. $\partial B_y/\partial y$ ist direkt proportional zu $A_z$, wobei im Falle einer ersten symmetrischen Schwingungsmode gilt:

$$K \;=\; \partial B_y/\partial x \;=\; (A_z * 384 * E * J_y)/(m * l^3),$$

wobei $J_y$ das axiale Flächenträgheitsmoment des Balkens 2 bezüglich der ersten Richtung y ist. Die räumliche Auflösung der Messung von K in Richtung x wird also festgelegt durch die Länge l des Balkens 2.

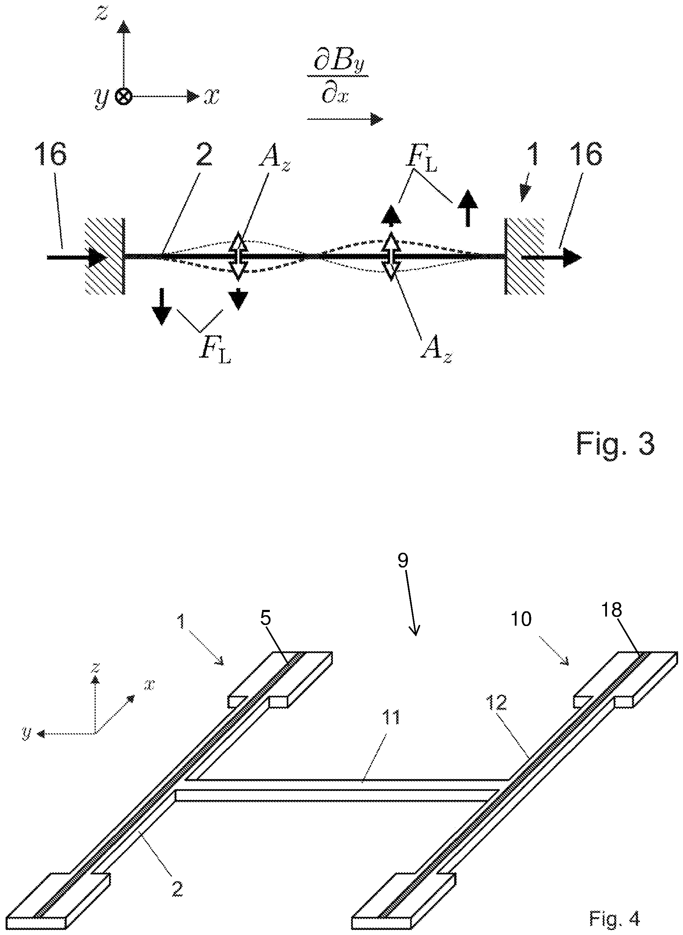

Bei Überlagerung des Gradienten durch ein Gleichfeld ungleich null kann die Anregung einer antisymmetrischen Schwingungsmode zur Bestimmung der Größe der Komponente des Gradiententensors von B vorteilhaft sein, um eine Unterscheidung zwischen Gleichfeld-Komponente und Gradiententensor-Komponente zu vereinfachen. Im Ausführungsbeispiel der Fig. 3 wird entsprechend die Amplitude $A_z$ der dargestellten antisymmetrischen Schwingungsmode des Balkens 2 gemessen, um unmittelbar auf die Größe von K bzw. $\partial B_y/\partial x$ zu schließen.

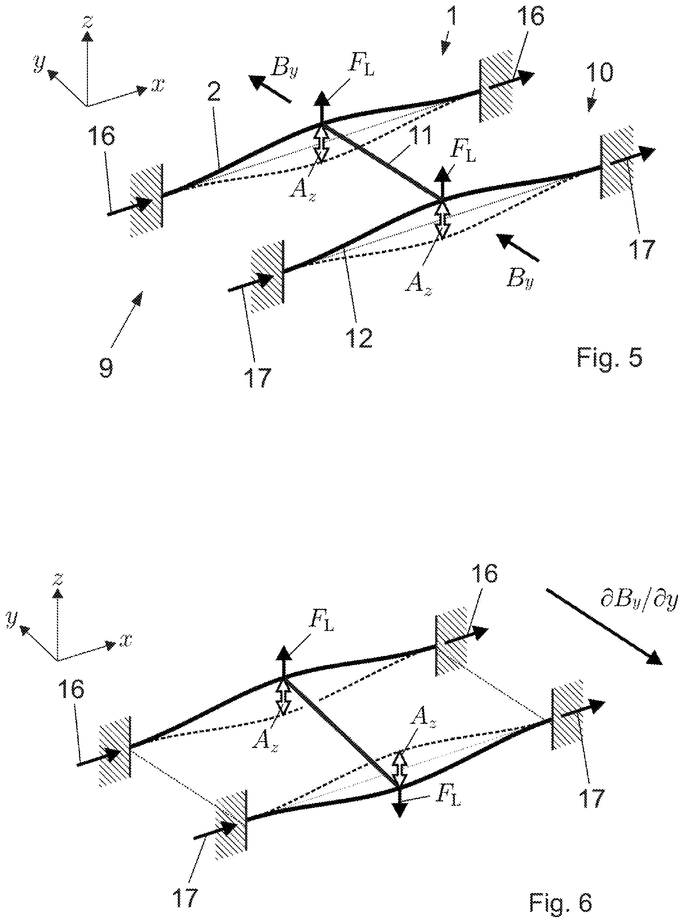

Fig. 4 zeigt eine Anordnung 9 bestehend aus dem Sensor 1 und einem zweiten Sensor 10 mit einem zweiten Balken 12 und einer zweiten Leiterbahn 18, wobei der zweite Sensor 10 im Aufbau grundsätzlich dem ersten Sensor 1 entspricht. Auch die zweite Leiterbahn 18 ist mit einer Wechselspannung beaufschlagbar, wobei sich ein zweiter Wechselstrom 17 einstellt (vgl. Fig. 5), sodass in einem Magnetfeld der zweite Balken 12 zu Schwingungen angeregt werden kann.

Die beiden Balken 2, 12 sind über ein Kopplungselement 11 miteinander verbunden, wobei sich eine H-Form der Anordnung 9 ergibt. Dabei sind die beiden Sensoren 1, 10 bzw. die Balken 2, 12 parallel zueinander angeordnet und nur in der ersten Richtung y voneinander beabstandet. Das Kopplungselement 11 stellt sicher, dass beide Balken 2, 12 mit derselben Frequenz schwingen.

Der erste Sensor 1 der Fig. 1 bis Fig. 3 sowie die Anordnung 9 der Fig. 4 mit dem ersten Sensor 1, dem zweiten Sensor 10 und dem Kopplungselement 11 können z.B. aus vorzugsweise einkristallinem Silizium gefertigt sein. Die Leiterbahnen 5, 18 können beispielsweise aus Gold gefertigt sein. Der Sensor 1 bzw. die Anordnung 9 können dabei mittels der an sich bekannten Silicon-On-Insulator (SOI)-Technologie hergestellt sein.

Durch die Kopplung der beiden Sensoren 1, 10 wird einerseits eine erhöhte Empfindlichkeit auf Komponenten des Gradiententensors entlang der Längsrichtung x erzielt, also auf Komponenten des Gradiententensors mit einer partiellen Ableitung nach einer räumlichen Koordinate, die der Richtung x entspricht. Andererseits wird durch die Beabstandung der beiden Balken 2, 12 in der ersten Richtung y automatisch eine Empfindlichkeit der Anordnung 9 auf Komponenten des Gradiententensors entlang der ersten Richtung y erzielt.

Fig. 5 zeigt zunächst den Fall eines magnetischen Gleichfeldes mit einer B-Komponente in der ersten Richtung y ungleich 0, also $B_y \neq 0$. Analog zu Fig. 2 schwingen beide Balken 2, 12, mit einer symmetrischen Schwingungsmode mit der Amplitude $A_z$ in der zweiten Richtung z. Dabei schwingen die beiden Balken 2, 12 gleichphasig. Die beiden Wechselspannungen bzw. der erste Wechselstrom 16 und der zweite Wechselstrom 17 weisen nicht nur dieselbe Frequenz $f_i$ auf, sondern sind auch gleichphasig.

Fig. 6 zeigt hingegen den Fall mit einer nichtverschwindenden Gradiententensorkomponente entlang der ersten Richtung, konkret $\partial B_y/\partial y \neq 0$, wobei aus Gründen der Klarheit der Effekt des nichtverschwindenden Gleichfelds $B_y$ nicht dargestellt ist, was einem im Mittel verschwindenden Gleichfeldanteil $B_y = 0$ entspricht. Wieder sind die beiden Wechselspannungen bzw. die beiden Wechselströme 16, 17 gleichphasig und wieder schwingen die beiden Balken 2, 12 jeweils mit einer symmetrischen Schwingungsmode mit der Amplitude $A_z$ in der zweiten Richtung z. Aufgrund der Gradiententensorkomponente $\partial B_y/\partial y \neq 0$ ergibt sich in diesem Fall jedoch eine gegenphasige Schwingung der Balken 2, 12.

Neben der eindeutigen Identifikation des Vorhandenseins der Gradiententensorkomponente $\partial B_y/\partial y$ bietet die gegenphasige Auslenkung der beiden Balken 2, 12 den messtechnischen Vorteil, dass ohne großen Aufwand ein Differenzsignal aus den Messungen der Amplituden $A_z$ gewonnen werden kann. Dabei kann die Messung der Amplitude(n) mit unterschiedlichsten Auslesemitteln erfolgen, welche z.B. kapazitive, piezoelektrische, piezoresistive oder optische Ausleseelemente umfassen können.

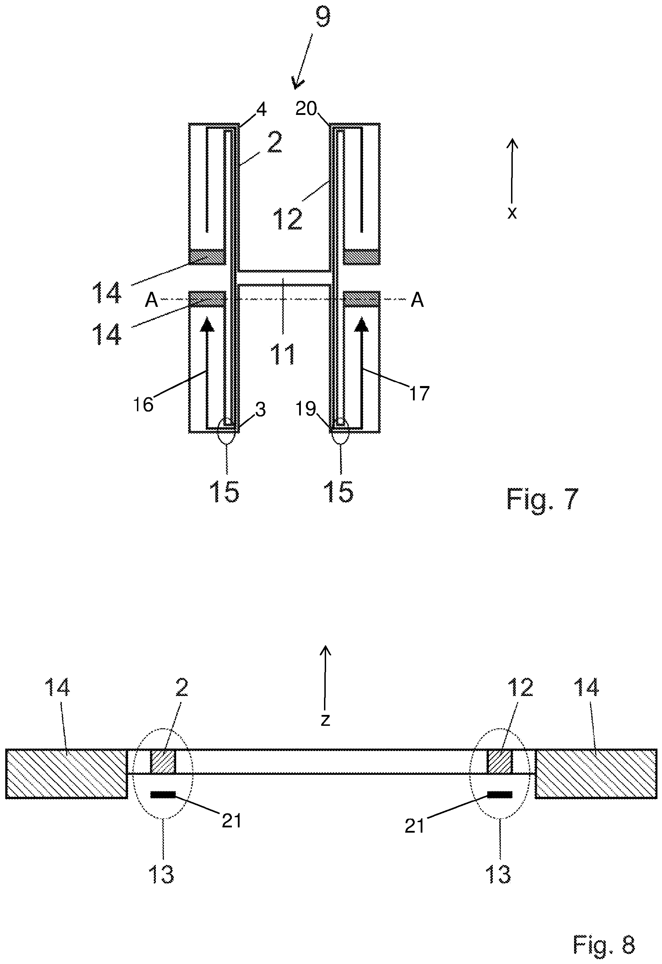

Fig. 7 zeigt eine Aufsicht auf eine erfindungsgemäße Anordnung 9 mit gleichphasigen Wechselströmen 16, 17. Die Balken 2, 12 sind in ihren Anfangsbereichen 3, 19 und Endbereichen 4, 20 an jeweils einem Ankerelement 14 fixiert. Konkret ist jeder Balken 2, 12 sowohl in seinem Anfangsbereich 3, 19 als auch in seinem Endbereich 4, 20 über jeweils einen Verbindungsabschnitt 15 mit jeweils einem Ankerelement 14 verbunden. Wie die Balken 2, 12 unterliegen auch die Ankerelemente 14 einer thermisch bedingten Ausdehnung. Indem die Ankerelemente 14 als Kragarme ausgeführt und entsprechend angeordnet sind, bewirkt die thermische Ausdehnung der Ankerelemente 14, dass es zu keinem thermisch bedingten Wölben der Balken 2, 12 kommt. In diesem Sinne kompensiert die thermische Ausdehnung der Ankerelemente 14 die thermische Ausdehnung der Balken 2, 12 bzw. der Anordnung 9. Herstellungstechnisch vorteilhaft können Balken 2, 12, Kopplungselement 11, Verbindungsabschnitte 15 und Ankerelemente 14 einstückig ausgeführt sein, wobei vorzugsweise die SOI-Technologie für die Fertigung Verwendung findet.

Fig. 8 zeigt einen Schnitt gemäß der Schnittlinie A-A in Fig. 7. Hierbei sind kapazitive Ausleseelemente 13 zur Bestimmung der Auslenkung der Balken 2, 12 in der zweiten Richtung z bzw. zur Bestimmung der Amplitude $A_z$ der Balken 2, 12 erkennbar. Die Ausleseelemente 13 sind durch die punktierten Linien angedeutet. Die Ausleseelemente 13 werden gebildet jeweils durch einen der Balken 2, 12 samt zugehörigem Leitmittel bzw. samt zugehöriger Leiterbahn 5, 18 und eine unter dem jeweiligen Balken 2, 12 angeordnete Elektrode 21, welche beispielsweise als Leiterbahn ausgeführt sein kann. Mit der Amplitude $A_z$ ändert sich der Abstand zwischen dem Balken 2, 12 und der zugehörigen Elektrode 21, wodurch sich die kapazitive Kopplung zwischen der jeweiligen Elektrode 21 und der jeweiligen Leiterbahn 5, 18 bzw. die sich ergebende Kapazität ändert. Die Kapazitätsänderung ist also ein direktes Maß für die Amplitude $A_z$.

BEZUGSZEICHENLISTE

| | |
|---|---|
| 1 | Sensor |
| 2 | Balken |
| 3 | Anfangsbereich des Balkens in Längsrichtung |
| 4 | Endbereich des Balkens in Längsrichtung |
| 5 | Leiterbahn |
| 6 | Oberfläche |
| 7 | Breite des Balkens |
| 8 | Höhe des Balkens |
| 9 | Anordnung von Sensoren |
| 10 | Zweiter Sensor |
| 11 | Kopplungselement |
| 12 | Balken des zweiten Sensors |
| 13 | Kapazitives Ausleseelement |
| 14 | Ankerelement |
| 15 | Verbindungsabschnitt |
| 16 | Wechselstrom |
| 17 | Zweiter Wechselstrom |
| 18 | Zweite Leiterbahn |
| 19 | Anfangsbereich des zweiten Balkens |
| 20 | Endbereich des zweiten Balkens |
| 21 | Elektrode |
| x | Längsrichtung |
| y | erste Richtung bzw. Richtung entlang der Breite des Balkens |
| z | zweite Richtung bzw. Richtung entlang der Höhe des Balkens |
| $F_L$ | Lorentz-Kraft |
| $A_z$ | Amplitude in z-Richtung |
| $J_y$ | axiales Flächenträgheitsmoment des Balkens bezüglich der y-Richtung |
| E | Elastizitätsmodul des Balkens |
| l | Länge des Balkens |
| m | magnetisches Moment |
| K | Komponente eines Gradiententensors |
| B | magnetische Flussdichte |
| $A_a$ | in allgemeiner Richtung gemessene Amplitude |
| a | allgemeine Richtung |
| a' | Normalrichtung |
| $J_{a'}$ | axiales Flächenträgheitsmoment des Balkens bezüglich der Normalrichtung |

**Patentansprüche**

1. Gradientenmagnetometer umfassend eine Anordnung mehrerer Sensoren (1), wobei jeder Sensor (1) einen geradlinigen Balken (2) umfasst, welcher in seiner Längsrichtung (x) gesehen in einem Anfangsbereich (3) und einem Endbereich (4) fixiert ist und dazwischen frei schwingen kann, jeder Sensor (1) weiters umfassend mindestens ein am Balken (2) angeordnetes und mit diesem verbundenes Leitmittel (5), um einen Stromfluss in Form von bewegten Ladungsträgern zwischen dem Anfangsbereich (3) und dem Endbereich (4) zu ermöglichen, wobei das mindestens eine Leitmittel (5) mit einer Wechselspannung beaufschlagbar ist, um unter Ausnutzung der Lorentz-Kraft ($F_L$) eine Schwingungsmode des Balkens (2) anzuregen, wenn sich der Balken (2) in einem Magnetfeld befindet, wobei mindestens zwei Sensoren (1) miteinander mechanisch gekoppelt sind, um bei Anregung einer Schwindung der Balken (2) dieser mindestens zwei Sensoren (1) dieselbe Schwingungsfrequenz zu erzwingen, **dadurch gekennzeichnet, dass** für jeden Sensor (1) mindestens ein Auslesemittel vorgesehen ist, um eine Amplitude ($A_a$, $A_z$) der Schwingung des Balkens (2) des jeweiligen Sensors (1) zu bestimmen.

2. Gradientenmagnetometer nach Anspruch 1, **dadurch gekennzeichnet, dass** der Balken (2) jedes Sensors (1) in Längsrichtung (x) zwischen dem Anfangsbereich (3) und dem Endbereich (4) eine Länge (l) aufweist, dass der Balken (2) in einer ersten Richtung (y) normal auf die Längsrichtung (x) eine Breite (7) aufweist und in einer zweiten Richtung (z), die normal auf die Längsrichtung (x) und die erste Richtung (y) steht, eine Höhe (8), wobei die Höhe (8) kleiner als die Breite (7) ist und die Breite (7) kleiner als die Länge (l).

3. Gradientenmagnetometer nach Anspruch 2, **dadurch gekennzeichnet, dass** die Breite (7) mindestens zehnmal größer, vorzugsweise mindestens dreißigmal größer, als die Höhe (8) ist und die Länge (l) mindestens zehnmal größer, vorzugsweise mindestens dreißigmal größer als die Breite (7) .

4. Gradientenmagnetometer nach einem der Ansprüche 1 bis 3, **dadurch gekennzeichnet, dass** der Balken (2) jedes Sensors (1) aus vorzugsweise einkristallinem Silizium gefertigt ist.

5. Gradientenmagnetometer nach einem der Ansprüche 1 bis 4, **dadurch gekennzeichnet, dass** das mindestens eine Leitmittel eine Leiterbahn (5) umfasst, die auf einer Oberfläche (6) des Balkens (2) jedes Sensors (1) fixiert ist.

6. Gradientenmagnetometer nach einem der Ansprüche 1 bis 4, **dadurch gekennzeichnet, dass** das mindestens eine Leitmittel (5) in den Balken (2) jedes Sensors (1) integriert ist.

7. Gradientenmagnetometer nach Anspruch 6, **dadurch gekennzeichnet, dass** der Balken (2) und das mindestens eine Leitmittel (5) jedes Sensors (1) einstückig ausgeführt sind.

8. Gradientenmagnetometer nach einem der Ansprüche 1 bis 7, **dadurch gekennzeichnet, dass** genau zwei Sensoren (1, 10) vorgesehen sind, deren Balken (2, 12) mittels mindestens eines Kopplungselements (11) miteinander verbunden sind, wobei die Anordnung im Wesentlichen eine H-Form aufweist.

9. Gradientenmagnetometer nach Anspruch 8, **dadurch gekennzeichnet, dass** die Balken (2, 12) der beiden Sensoren (1, 10) parallel zueinander verlaufen und im Wesentlichen nur in der ersten Richtung (y) voneinander beabstandet sind.

10. Gradientenmagnetometer nach einem der Ansprüche 8 bis 9, **dadurch gekennzeichnet, dass** die beiden Balken (2, 12) und das mindestens eine Kopplungselement (11) einstückig ausgeführt sind.

11. Gradientenmagnetometer nach einem der Ansprüche 8 bis 10, **dadurch gekennzeichnet, dass** jeder Balken (2, 12) in seinem Anfangsbereich (3) und in seinem Endbereich (4) an jeweils einem als Kragarm ausgeführten Ankerelement (14) fixiert ist.

12. Verfahren zur Bestimmung einer einzelnen Komponente (K) eines Gradiententensors eines Magnetfelds unter Verwendung eines Sensors (1) mit einem geradlinigen Balken (2), welcher in seiner Längsrichtung (x) gesehen in einem Anfangsbereich (3) und einem Endbereich (4) fixiert ist und dazwischen frei schwingen kann, der Sensor (1) weiters umfassend mindestens ein am Balken (2) angeordnetes und mit diesem verbundenes Leitmittel (5), um einen Stromfluss in Form von bewegten Ladungsträgern zwischen dem Anfangsbereich (3) und dem Endbereich (4) zu ermöglichen, das Verfahren umfassend die folgenden Schritte:

   - Anregen einer vorzugsweise antisymmetrischen Schwingungsmode des Balkens (2) des Sensors (1) durch Ausnutzung der Lorentz-Kraft ($F_L$), indem das mindestens eine Leitmittel (5) mit einer Wechselspannung mit einer Frequenz $f_i$ beaufschlagt wird, wobei $f_i$ eine Frequenz einer Schwingungsmode des Balkens (2) ist;

   **dadurch gekennzeichnet, dass** das Verfahren die folgenden Schritte umfasst:

- Bestimmung einer Amplitude ($A_a$) der angeregten Schwingung;
- Berechnung der Größe der Komponente (K) gemäß der folgenden Formel:

$$K = A_a * \alpha(E, J_{a'}, m, l),$$

wobei K die Komponente der magnetischen Flussdichte (B) in einer Normalrichtung (a'), die normal auf die Richtung der gemessenen Amplitude $A_a$ und normal auf die Längsrichtung (x) steht, partiell abgeleitet nach der Längsrichtung (x) ist und $\alpha$ ein Proportionalitätsfaktor, der vom Elastizitätsmodul E des Balkens (2), vom axialen Flächenträgheitsmoment $J_{a'}$ des Balkens (2) bezüglich der Normalrichtung (a'), vom magnetischen Moment m, das sich aus dem Stromfluss im Leitmittel (5) und der vom Stromfluss umschlossenen Fläche ergibt, sowie von der Länge l des Balkens (2) abhängt,

und wobei gleichzeitig mit der Anregung der Schwingung des Balkens (2) des Sensors (1) eine Schwingung des Balkens (12) eines zweiten Sensors (10), welcher mit dem Sensor (1) mechanisch gekoppelt ist, durch Ausnutzung der Lorentz-Kraft ($F_L$) angeregt wird, indem das mindestens eine Leitmittel (5) des zweiten Sensors (10) mit einer Wechselspannung mit derselben Frequenz $f_i$ beaufschlagt wird, und dass die Amplituden ($A_a$) der angeregten Schwingung der beiden Balken (2, 12) bestimmt werden.

**13.** Verfahren nach Anspruch 12, **dadurch gekennzeichnet, dass** die Amplitude in der zweiten Richtung (z) gemessen wird und dass die Komponente (K) des Gradiententensors gemäß der folgenden Formel bestimmt wird

$$K = A_z * \alpha(E, J_y, m, l),$$

wobei K die Komponente der magnetischen Flussdichte (B) in der ersten Richtung (y) partiell abgeleitet nach der Längsrichtung (x) ist, $A_z$ die entlang der zweiten Richtung (z) gemessene Amplitude und $J_y$ das axiale Flächenträgheitsmoment des Balkens (2, 12) bezüglich der ersten Richtung (y).

**14.** Verfahren nach einem der Ansprüche 12 bis 13, **dadurch gekennzeichnet, dass** außerdem bestimmt wird, ob die Schwingung der beiden Balken (2, 12) in Phase oder gegenphasig ist.

**15.** Verfahren nach einem der Ansprüche 12 bis 14, **dadurch gekennzeichnet, dass** die beiden Wechselspannungen gegenphasig sind.

**Claims**

**1.** A gradient magnetometer, comprising an arrangement of a plurality of sensors (1), wherein each sensor (1) comprises a rectilinear beam (2) which is fixed, as seen in its longitudinal direction (x), in an initial region (3) and an end region (4) and which is capable of oscillating freely therebetween, each sensor (1) further comprising at least one conducting means (5) arranged on and connected to the beam (2) to allow a current flow in the form of moving charge carriers between the initial region (3) and the end region (4), wherein the at least one conducting means (5) can be acted upon by an alternating voltage in order to excite an oscillating mode of the beam (2) by utilizing the Lorentz force ($F_L$) when the beam (2) is in a magnetic field, wherein at least two sensors (1) are mechanically coupled to each other in order to force the same oscillation frequency upon excitation of an oscillation of the beams (2) of these at least two sensors (1), **characterized in that** at least one read-out means is provided for each sensor (1) to determine an amplitude ($A_a$, $A_z$) of the oscillation of the beam (2) of the respective sensor (1).

**2.** Gradient magnetometer according to claim 1, **characterized in that** the beam (2) of each sensor (1) has a length (1) in the longitudinal direction (x) between the initial region (3) and the end region (4), that the beam (2) has a width (7) in a first direction (y) normal to the longitudinal direction (x) and a height (8) in a second direction (z) which is normal to the longitudinal direction (x) and the first direction (y), wherein the height (8) is smaller than the width (7) and the width (7) is smaller than the length (1).

**3.** Gradient magnetometer according to claim 2, **characterized in that** the width (7) is at least ten times greater, preferably at least thirty times greater, than the height (8) and the length (1) is at least ten times greater, preferably at least thirty times greater, than the width (7),

4. Gradient magnetometer according to one of the claims 1 to 3, **characterized in that** the beam (2) of each sensor is made of preferably monocrystalline silicon.

5. Gradient magnetometer according to one of the claims 1 to 4, **characterized in that** the at least one conducting means comprises a conductor track (5) which is fixed to a surface (6) of the beam (2) of each sensor (1).

6. Gradient magnetometer according to one of the claims 1 to 4, **characterized in that** the at least one conducting means (5) is integrated in the beam (2) of each sensor (1).

7. Gradient magnetometer according to claim 6, **characterized in that** the beam (2) and the at least one conducting means (5) of each sensor (1) are made in one piece.

8. Gradient magnetometer according to one of the claims 1 to 7, **characterized in that** exactly two sensors (1, 10) are provided, the beams (2, 12) of which are interconnected by means of at least one coupling element (11), wherein the arrangement substantially has an H-shape.

9. Gradient magnetometer according to claim 8, **characterized in that** the beams (2, 12) of the two sensors (1, 10) extend in parallel to each other and are spaced apart substantially only in the first direction (y).

10. Gradient magnetometer according to one of the claims 8 to 9, **characterized in that** the two beams (2, 12) and the at least one coupling element (11) are made in one piece.

11. Gradient magnetometer according to one of the claims 8 to 10, **characterized in that** each beam (2, 12) is fixed in its initial region (3) and in its end region (4) to a respective armature element (14) which is designed in each case as a cantilever arm.

12. Method for determining a single component (K) of a gradient sensor of a magnetic field by using a sensor (1) with a rectilinear beam (2) which is fixed, as seen in its longitudinal direction (x), in an initial region (3) and an end region (4) and which is capable of oscillating freely therebetween, the sensor (1) further comprising at least one conducting means (5) arranged on and connected to the beam (2), in order to allow a current flow in the form of moving charge carriers between the initial region (3) and the end region (4), the method comprising the following steps:

- exciting a preferably antisymmetric oscillating mode of the beam (2) of the sensor (1) by utilizing the Lorentz force ($F_L$) in that the at least one conducting means (5) is subjected to an alternating voltage having a frequency $f_i$, wherein $f_i$ is a frequency of an oscillating mode of the beam(2) ;

**characterized in that** the method comprises the following steps:

- determining an amplitude ($A_a$) of the excited oscillation;
- calculation of the size of the component (K) according to the following formula:

$$K \;=\; A_a \;\ast\; \boldsymbol{\alpha}(E, J_{a'}, m, l),$$

wherein K is the component of magnetic flux density (B) in a normal direction (a') which is normal to the direction of the measured amplitude $A_a$ and normal to the longitudinal direction (x), partially derived after the longitudinal direction (x), and $\alpha$ is a proportionality factor which depends on the elasticity modulus E of the beam (2), on the axial area moment of inertia $J_{a'}$ of the beam (2) with respect to the normal direction (a'), on the magnetic moment m, resulting from the current flow in the conducting means (5) and the area enclosed by the current flow, and on the length 1 of the beam (2),

and wherein simultaneously with the excitation of the oscillation of the beam (2) of the sensor (1) an oscillation of the beam (12) of a second sensor (10), which is mechanically coupled to the sensor (1), is excited by utilizing the Lorentz force ($F_L$) **in that** the at least one conducting means (5) of the second sensor (10) is subjected to an alternating voltage having the same frequency $f_i$, and that the amplitudes ($A_a$) of the excited oscillation of the two beams (2, 12) are determined.

13. Method according to claim 12, **characterized in that** the amplitude in the second direction (z) is measured and that the component (K) of the gradient sensor is determined according to the following formula:

$$K = A_z \ast \boldsymbol{\alpha}(E, J_y, m, l),$$

wherein K is the component of the magnetic flux density (B) in the first direction (y) partially derived after the longitudinal direction (x), $A_z$ is the amplitude measured along the second direction (z) and $J_y$ is the axial moment of inertia of the beam (2, 12) with respect to the first direction (y).

14. Method according to one of the claims 12 to 13, **characterized in that** it is also determined whether the oscillation of the two beams (2, 12) is in phase or in antiphase.

15. Method according to one of the claims 12 to 14, **characterized in that** the two alternating voltages are in antiphase.

**Revendications**

1. Magnétomètre à gradient comprenant une disposition de plusieurs capteurs (1) dans laquelle chaque capteur (1) comprend une barre rectiligne (2) qui est fixée, vue dans la direction longitudinale (x), dans une zone de début (3) et une zone de fin (4) et qui peut vibrer librement entre celles-ci, chaque capteur (1) comprenant en outre au moins un moyen de conduction (5) disposé sur la barre (2) et relié à celle-ci afin de permettre un écoulement de courant sous la forme d'un déplacement de porteurs de charge entre la zone de début (3) et la zone de fin (4), l'au moins un moyen de conduction (5) pouvant recevoir une tension alternative afin de susciter un mode de vibration de la barre (2) en exploitant la force de Lorentz ($F_L$) quand la barre (2) se trouve dans un champ magnétique, au moins deux capteurs (1) étant couplés mécaniquement l'un à l'autre afin d'imposer la même fréquence de vibration quand des vibrations des barres (2) de ces au moins deux capteurs (1) sont suscitées, **caractérisé en ce qu'**il est prévu pour chaque capteur (1) au moins un moyen de lecture pour déterminer une amplitude ($A_a$, $A_z$) des vibrations de la barre (2) du capteur (1) en question.

2. Magnétomètre à gradient selon la revendication 1, **caractérisé en ce que** la barre (2) chaque capteur (1) présente dans la direction longitudinale (x) entre la zone de début (3) et la zone de fin (4) une longueur (1) telle que la barre (2) présente dans une première direction (y) perpendiculaire à la direction longitudinale (x) une largeur (7) et dans une deuxième direction (z) perpendiculaire à la direction longitudinale (x) et à la première direction (y) une hauteur (8), la hauteur (8) étant plus petite que la largeur (7) et la largeur (7) plus petite que la longueur (1).

3. Magnétomètre à gradient selon la revendication 2, **caractérisé en ce que** la largeur (7) est au moins dix fois plus grande, de préférence au moins trente fois plus grande que la hauteur (8) et la longueur (1) est au moins dix fois plus grande, de préférence au moins trente fois plus grande que la largeur (7).

4. Magnétomètre à gradient selon l'une des revendications 1 à 3, **caractérisé en ce que** la barre (2) de chaque capteur (1) est faite de silicium, de préférence monocristallin.

5. Magnétomètre à gradient selon l'une des revendications 1 à 4, **caractérisé en ce que** l'au moins un moyen de conduction comprend une piste conductrice (5) qui est fixée sur une surface (6) de la barre (2) chaque capteur (1).

6. Magnétomètre à gradient selon l'une des revendications 1 à 4, **caractérisé en ce que** l'au moins un moyen de conduction (5) est intégré dans la barre (2) de chaque capteur (1).

7. Magnétomètre à gradient selon la revendication 6, **caractérisé en ce que** la barre (2) et l'au moins un moyen de conduction (5) de chaque capteur (1) sont réalisés d'une pièce.

8. Magnétomètre à gradient selon l'une des revendications 1 à 7, **caractérisé en ce que** sont prévus exactement deux capteurs (1, 10) dont les barres (2, 12) sont reliées l'une à l'autre au moyen d'au moins un élément de couplage (11), la disposition présentant sensiblement la forme d'un H.

9. Magnétomètre à gradient selon la revendication 8, **caractérisé en ce que** les barres (2, 12) des deux capteurs (1, 10) sont parallèles l'une à l'autre et ne sont distantes l'une de l'autre, pour l'essentiel, que dans la première direction (y).

10. Magnétomètre à gradient selon l'une des revendications 8 à 9, **caractérisé en ce que** les deux barres (2, 12) et l'au moins un élément de couplage (11) sont réalisées d'une pièce.

11. Magnétomètre à gradient selon l'une des revendications 8 à 10, **caractérisé en ce que** chaque barre (2, 12) est fixé dans sa zone de début (3) et dans sa zone de fin (4) sur un élément d'ancrage (14) réalisé comme un bras en porte-à-faux.

12. Procédé pour la détermination une individuelle composante (K) d'un tenseur de gradient d'un champ magnétique à l'aide d'un capteur (1) muni d'une barre rectiligne (2) qui est fixée, vue dans la direction longitudinale (x), dans une zone de début (3) et une zone de fin (4) et qui peut vibrer librement entre celles-ci, le capteur (1) comprenant en outre au moins un moyen de conduction (5) disposé sur la barre (2) et relié à celle-ci, afin de permettre un écoulement de courant sous la forme d'un déplacement de porteurs de charge entre la zone de début (3) et la zone de fin (4), lequel procédé comprend au moins les étapes suivantes :

- excitation d'un mode vibratoire de préférence antisymétrique de la barre (2) du capteur (1) en exploitant la force de Lorentz ($F_L$) par le fait que l'au moins un moyen de conduction (5) reçoit une tension alternative de fréquence $f_i$, où $f_i$ est une fréquence d'un mode vibratoire de la barre (2) ;

**caractérisé en ce que** le procédé comprend les étapes suivantes :

- détermination d'une amplitude ($A_a$) des vibrations suscitées ;
- calcul de la grandeur de la composante (K) selon la formule suivante :

$$K = A_a * \alpha(E, J_{a'}, m, l),$$

où K est la composante de la densité de flux magnétique (B) dans une direction normale (a') perpendiculaire à la direction de l'amplitude mesurée $A_a$ et perpendiculaire à la direction longitudinale (x), partiellement dérivée vers le sens de la longueur (x), et $\alpha$ est un facteur de proportionnalité qui dépend du module d'élasticité E de la barre (2), du moment d'inertie de surface axial $J_{a'}$ de la barre (2) par rapport à la direction normale (a'), du moment magnétique m résultant du flux du courant dans le moyen de conduction (5) et de la surface entourée par le flux de courant, ainsi que de la longueur 1 de la barre (2),

et dans lequel, en même temps que les vibrations de la barre (2) du capteur (1) sont suscitées, des vibrations de la barre (12) d'une deuxième capteur (10) couplé mécaniquement au capteur (1) sont suscitées en exploitant la force de Lorentz ($F_L$) par le fait que l'au moins un moyen de conduction (5) du deuxième capteur (10) reçoit une tension alternative de la même fréquence $f_i$, et **en ce que** les amplitudes ($A_a$) des vibrations suscitées des deux barres (2, 12) sont déterminées.

13. Procédé selon la revendication 12, **caractérisé en ce que** l'amplitude est mesurée dans la deuxième direction (z) et **en ce que** la composante (K) du capteur de gradient est déterminée selon la formule suivante :

$$K = A_z * \alpha(E, J_y, m, l),$$

où K est la composante de la densité de flux magnétique (B) dans la première direction (y) partiellement dérivée vers la direction longitudinale (x), $A_z$ est l'amplitude mesurée dans la deuxième direction (z) et $J_y$ le moment d'inertie surfacique de la barre (2, 12) par rapport à la première direction (y).

14. Procédé selon l'une des revendications 12 à 13, **caractérisé en ce qu'**il est déterminé en outre si les vibrations des deux barres (2, 12) sont en phase ou de phase opposée.

15. Procédé selon l'une des revendications 12 à 14, **caractérisé en ce que** les deux tensions alternatives sont de

phase opposée.

Fig. 1

Fig. 2

Fig. 3

Fig. 4

Fig. 5

Fig. 6

9

4  20

2

12

14

A ·—·—·—·—·—·—· A

14

11

16  17

15  15

Fig. 7

14  2  12  14

z

21  21

13  13

Fig. 8

EP 3 060 933 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2005062064 A1
- WO 0068702 A1
- US 2006181273 A1
- US 2010295546 A1
- DE 19809742 A1

**In der Beschreibung aufgeführte Nicht-Patentliteratur**

- **A.L. HERRERA-MAY et al.** Resonant Magnetic Field Sensors Based on MEMS Technology. *Sensors,* 2009, vol. 9, 7785-7813
- **STEPHEN P. TIMOSHENKO ; JAMES M. GERE.** Theory of Elastic Stability. McGraw-Hill, 1985
- **KURT MAGNUS ; KARL POPP.** Schwingungen. Vieweg+Teubner Verlag, 2005